# EUROPÄISCHE PATENTSCHRIFT

(11) **EP 0 954 896 B1**
(45) Veröffentlichungstag und Bekanntmachung des Hinweises auf die Patenterteilung: **16.08.2001**
(21) Anmeldenummer: 97909176.6
(22) Anmeldetag: 23.09.1997
(51) Int. Cl.: H02M 3/07, G11C 5/14, G11C 16/06

(54) **SCHALTUNGSANORDNUNG ZUM ERZEUGEN NEGATIVER SPANNUNGEN**
CIRCUIT FOR GENERATING NEGATIVE VOLTAGES
CIRCUIT POUR PRODUIRE DES TENSIONS NEGATIVES

(30) Priorität: 24.01.1997 DE 19702535
(43) Veröffentlichungstag der Anmeldung: 10.11.1999
(73) Patentinhaber: Infineon Technologies AG, 81669 München (DE)
(72) Erfinder: BLOCH, Martin, D-82194 Gröbenzell (DE); LAUTERBACH, Christl, D-85635 Höhenkirchen-Siegertsbrunn (DE)
(74) Vertreter: Zedlitz, Peter, Dipl.-Inf.
(86) Internationale Anmeldenummer: DE9702154
(87) Internationale Veröffentlichungsnummer: WO9833264

(56) Entgegenhaltungen:
- EP-A- 0 319 063
- EP-A- 0 349 495
- EP-A- 0 616 329
- EP-A- 0 678 970
- US-A- 5 422 586
- US-A- 5 612 921
- AKIRA UMEZAWA ET AL: "A 5-V-ONLY OPERATION 0.6-UM FLASH EEPROM WITH ROW DECODER SCHEME IN TRIPLE-WELL STRUCTURE" IEEE JOURNAL OF SOLID-STATE CIRCUITS, Bd. 27, Nr. 11, 1.November 1992, Seiten 1540-1545, XP000320440

## Beschreibung

Die Erfindung betrifft eine Schaltungsanordnung zum Erzeugen negativer Spannungen mit einem ersten Transistor, dessen erster Anschluß mit einem Eingangsanschluß und dessen zweiter Anschluß mit einem Ausgangsanschluß der Schaltungsanordnung verbunden ist und dessen Gateanschluß über einen ersten Kondensator mit einem ersten Taktsignalanschluß verbunden ist, mit einem zweiten Transistor, dessen erster Anschluß mit dem Gateanschluß des ersten Transistors, dessen zweiter Anschluß mit dem zweiten Anschluß des ersten Transistors und dessen Gateanschluß mit dem ersten Anschluß des ersten Transistors verbunden ist und mit einem zweiten Kondensator, dessen erster Anschluß mit dem zweiten Anschluß des ersten Transistors und dessen zweiter Anschluß mit einem zweiten Taktsignalanschluß verbunden ist, wobei die Transistoren in zumindest einer Triple-Well ausgebildete MOS-Transistoren sind.

Eine solche Schaltungsanordnung ist aus der DE 196 01 369 C1 bekannt. Dort sind die Transistoren als n-Kanal-Transistoren in einer p-Wanne realisiert. Die p-Wanne ist ihrerseits in einer tiefen, isolierenden n-Wanne ausgebildet, welche in einem p-Substrat angeordnet ist.

Prinzipiell läßt sich die Schaltungsanordnung auf diese Weise auch mit p-MOS-Transistoren bei einem n-Substrat realisieren.

Die tiefe n-Wanne wird ebenso wie das p-Substrat mit Massepotential verbunden. Wenn nun die p-Wanne negativer vorgespannt wird als die negativste Spannung entweder am Drain- oder am Sourceanschluß des ersten Transistors, kann im eingeschwungenen Zustand der Schaltung auch über die parasitären Wannen-Substrat-Bipolartransistoren kein Leckstrom fließen. So bildet sich beispielsweise ein npn-Transistor durch das n⁺-Draingebiet des NMOS-Transistors, das als Emitter wirkt, die p-Wanne, die die Basis bildet und die n-Wanne, die den Kollektor bildet, aus. Wenn das Wannenpotential positiver ist als das Draingebiet des NMOS-Transistors, wird der parasitäre npn-Transistor leiten und die Effizienz der Ladungspumpe negativ beeinträchtigen.

Das Prinzip der bekannten als Ladungspumpe arbeitenden Schaltungsanordnung beruht darauf, daß Ladungen von einem Kondensator, der mit dem Drainanschluß des ersten Transistors verbunden ist, zu einem Kondensator, der mit dessen Sourceanschluß verbunden ist, "gepumpt" werden, indem abwechselnd eine Spannung an die jeweils weiteren Kondensatoranschlüsse gelegt wird. Wenn eine Anzahl N solcher Schaltungsanordnungen hintereinander geschaltet wird, der Eingang der ersten Schaltungsanordnung und der weitere Anschluß des mit dem Ausgang verbundenen Kondensators mit dem Masseanschluß verbunden sind, ist theoretisch eine Ausgangsspannung von |(N-1)U₀| zu erzielen, wobei Uₒ die Spannung an den Taktsignalanschlüssen ist.

Der Ladevorgang ist ein dynamischer Vorgang, bei dem sich ständig die Spannungen an den Source- und Drainanschlüssen der ersten Transistoren der Schaltungsanordnung ändern, so daß regelmäßig der parasitäre Bipolartransistor eingeschaltet wird.

Zur Lösung dieses Problems schlägt die DE 196 01 369 C1 vor, die Wannen, in denen die Transistoren angeordnet sind, mit den jeweiligen Sourceanschlüssen der Transistoren zu verbinden, da dort im eingeschwungenen Zustand die jeweils negativste Spannung anliegt. Diese Annahme gilt jedoch tatsächlich nur für den statischen Endzustand der Ladungspumpenschaltung, der in der Praxis eigentlich nie eintreten wird, da der Ladungspumpe ständig durch eine Last Ladung entnommen wird.

Bereits beim Einschalten wird bei der bekannten Schaltung die Wanne auf einem der Taktsignalspannung entsprechenden höheren Potential als der Drainanschluß liegen und somit der Bipolartransistor einschalten, was zu einem massiven Effizienzverlust führt, da hierdurch die Ladungspumpe einerseits nicht die theoretisch mögliche maximale Ausgangsspannung erreicht und andererseits die zu erzielende Ausgangsspannung deutlich langsamer annimmt.

Das vorliegender Erfindung zugrunde liegende Problem ist es daher, eine Schaltungsanordnung zum Erzeugen negativer Spannungen mit hoher Effizienz anzugeben.

Das Problem wird durch eine Schaltungsanordnung gemäß Anspruch 1 gelöst. Vorteilhafte Weiterbildungen sind in den Unteransprüchen angegeben.

Bei der erfindungsgemäßen Schaltungsanordnung bzw. der aus mehreren solchen Schaltungsanordnungen gebildetenen Ladungspumpen ist ein dritter Transistor vorgesehen, der die Wanne nur dann mit dem Sourceanschluß des ersten (Lade-)Transistors verbindet, wenn das Potential am Sourceanschluß negativer als das Potential am Drainanschluß des ersten Transistors ist. In diesem Fall wird der Wannenkondensator, der sich durch die pn-Sperrschicht zwischen den beiden Wannen ergibt, auf das Sourcepotential aufgeladen und hält die Wanne ausreichend lange auf diesem Potential, auch wenn der dritte Transistor wieder sperrt, weil das Drainanschlußpotential des ersten Transistors negativer als dessen sourceanschlußpotential wird.

In einer weiteren Ausführungsform der Erfindung ist ein vierter Transistor vorgesehen, der die Wanne mit dem Drainanschluß des ersten Transistors verbindet, wenn das Drainanschlußpotential negativer ist als das Sourceanschlußpotential des ersten Transistors. Bei dieser Ausführungsform wird der Wannenkondensator also immer auf das negativere Potential aufgeladen, so daß keine statischen Zustände eintreten können, in denen die Wanne positiver als einer der Anschlüsse des ersten Transistors ist und somit ein parasitärer Bipolartransistor leitend wird.

Eine weitere vorteilhafte Ausführungsform der Erfindung sieht vor, zwischen dem Drainanschluß des ersten Transistors und der Wanne einen Kondensator anzuordnen. Dieser Kondensator wird während der Einschaltphase des dritten Kondensators ebenso wie der Wannenkondensator auf das Sourceanschlußpotential aufgeladen und in der Sperrphase des dritten Transistors in Serie zum Wannenkondensator geschaltet, so daß bei einem Absinken des Drainanschlußpotentials die Spannung am Wannenkondensator zu negativeren Werten verschoben wird. Die Wanne ist daher negativer als durch ein reines Aufladen über den Sourceanschluß des ersten Transistors möglich wäre.

Durch Hintereinanderschalten mehrerer erfindungsgemäßer Schaltungsanordnungen kann eine Ladungspumpe geschaffen werden, mit der Spannungen von -12V oder gar -20V erzeugt werden können, wie sie für das Programmieren und/oder Löschen von nichtflüchtigen Speichern, insbesondere von Flash-EPROM-Speichern benötigt werden, bei Chipversorgungsspannungen von nur 2,5V.

Bei einer solchen Ladungspumpe werden die ungeradzahligen Schaltungsanordnungen mit einem ersten und zweiten Taktsignal beaufschlagt und die geradzahligen Schaltungsanordnungen mit dritten und vierten Taktsignalen, die den gleichen Verlauf wie die ersten und zweiten Taktsignale aufweisen, jedoch um eine halbe Periode verschoben sind. In vorteilhafter Weiterbildung weisen die Taktsignale am zweiten Taktsignalanschluß der Schaltungsanordnungen ein Tastverhältnis von mehr als 0,5 auf, so daß sich die zweiten und vierten Taktsignale überlappen. Hierdurch werden die ersten Transistoren vorgeladen, was zu einer Effizienzerhöhung führt.

Die Erfindung wird nachfolgend anhand von Ausführungsbeispielen mit Hilfe von Figuren näher erläutert. Dabei zeigen:
- Figur 1: ein detailliertes Schaltbild einer erfindungsgemäßen Schaltungsanordnung,
- Figur 2: eine Prinzipdarstellung einer Realisierung einer solchen Schaltungsanordnung in einem p-Substrat in Triple-Well-Technik,
- Figur 3: eine erste Ausführungsform einer Ladungspumpe,
- Figur 4: eine zweite Ausführungsform einer Ladungspumpe,
- Figur 5: eine dritte Ausführungsform einer Ladungspumpe, und
- Figur 6: den zeitlichen Verlauf der Taktsignale.

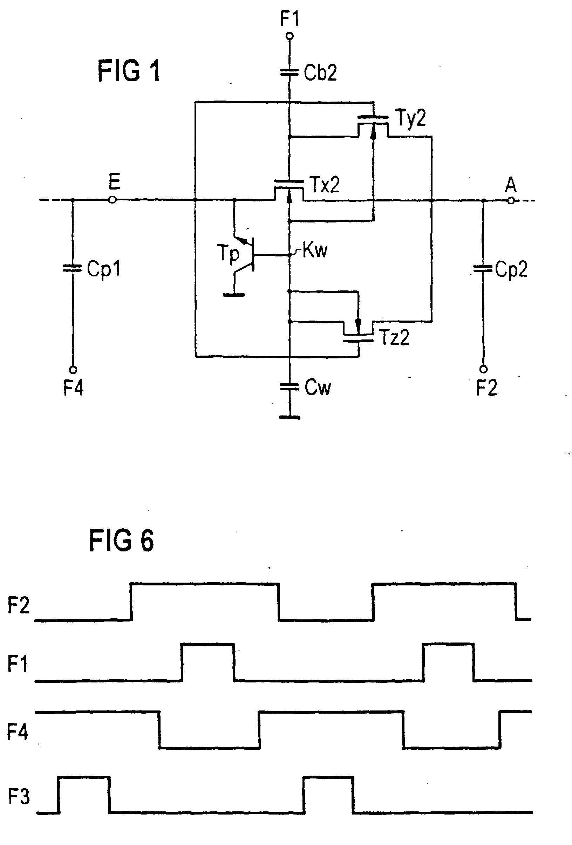

Gemäß Figur 1 ist bei der erfindungsgemäßen Schaltungsanordnung, die als eine Stufe einer mehrstufigen Ladungspumpe zur Erzeugung einer negativen Spannung betrachtet werden kann, zwischen einem Eingangsanschluß E und einem Ausgangsanschluß A ein erster NMOS-Transistor Tx2 geschaltet.

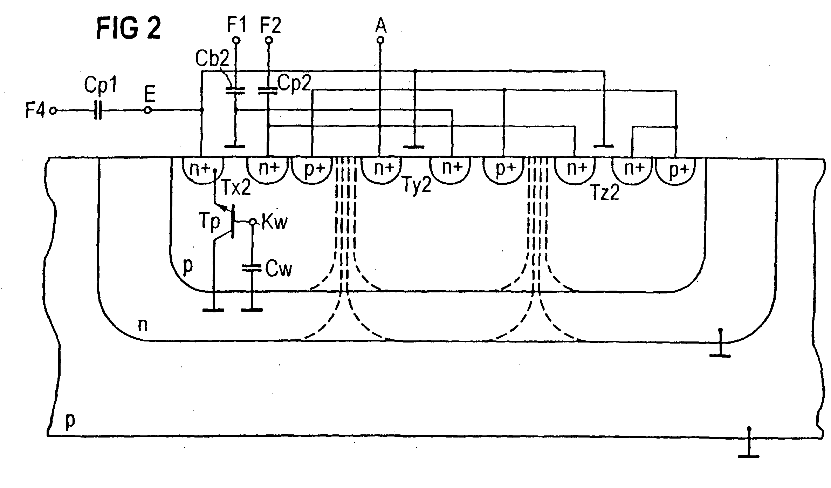

Wie in Figur 2 dargestellt ist, ist der erste Transistor Tx2 in einer p-Wanne ausgebildet, die ihrerseits in einer tiefen, isolierenden n-Wanne angeordnet ist. Diese tiefe n-Wanne ist in einem p-Substrat ausgebildet. Sowohl die n-Wanne als auch das p-Substrat sind an Masse angeschlossen.

Der Gateanschluß des ersten Transistors Tx2 ist über einen ersten Kondensator Cb2 mit einem ersten Taktsignalanschluß, an den ein erstes Taktsignal F1 angelegt werden kann, verbunden. Der Sourceanschluß des ersten Transistors Tx2 ist mit dem ersten Anschluß eines zweiten Kondensators Cp2 verbunden, dessen zweiter Anschluß mit einem zweiten Taktsignalanschluß, an den ein zweites Taktsignal F2 anlegbar ist, verbunden ist.

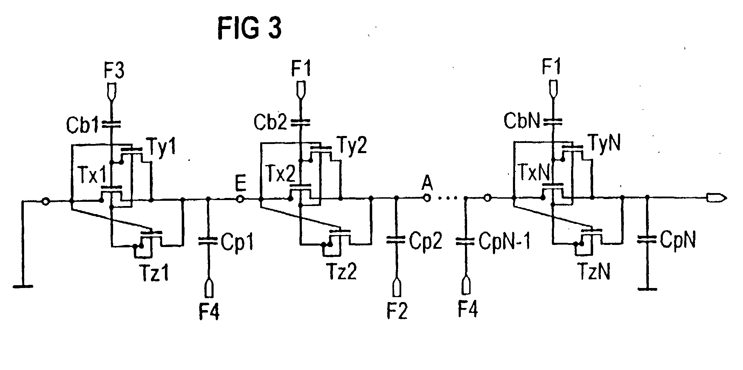

Der Eingangsanschluß E der Schaltungsanordnung kann mit dem Ausgangsanschluß einer weiteren gleichartigen Schaltungsanordnung verbunden sein, wie dies in Figur 3 ausführlich dargestellt ist und in Figur 1 durch den zweiten Kondensator Cp1 dieser weiteren Schaltungsanordnung angedeutet ist.

Wie in Figur 6 dargestellt ist, haben die zweiten und vierten Taktsignale F2, F4 den selben zeitlichen Verlauf, sind jedoch um eine halbe Periodendauer gegeneinander verschoben. Durch dieses abwechselnde Beaufschlagen der zweiten und vierten Taktsignalanschlüsse mit einer positiven Spannung werden Ladungen vom zweiten Kondensator Cp1 der weiteren bzw. vorangehenden Schaltungsanordnung einer Kette von Schaltungsanordnungen gemäß Figur 3 zum zweiten Kondensator Cp2 der nachfolgenden, in der Figur 1 dargestellten Schaltungsanordnung über den ersten Transistor Tx2 gepumpt. Dessen Gateanschluß wird während der Pumpphase durch das erste Taktsignal F1, dessen zeitlicher Verlauf ebenfalls in Figur 6 dargestellt ist, auf ein gegenüber dem Sourceanschluß des ersten Transistors Tx2 positives Potential gezogen, so daß dieser leitet. In vorteilhafter Weise überlappen sich die Taktsignale F2 und F4 etwas, so daß der erste Transistor vorgeladen wird, bevor er durch das erste Taktsignal F1 leitend geschaltet wird.

Durch das Pumpen von Ladungen zum zweiten Kondensator CP2 wird dieser aufgeladen und nach dem Abschalten des zweiten Taktsignals F2 der Ausgangsanschluß A bzw. der damit verbundene Sourceanschluß des ersten Transistors Tx2 negativ. Der Sourceanschluß würde damit negativer als der Gateanschluß des ersten Transistors Tx2, wodurch dieser nicht gesperrt würde und sich der zweite Kondensator CP2 wieder entladen könnte. Daher ist zwischen den Gateanschluß und den Sourceanschluß des ersten Transistors Tx2 ein zweiter Transistor Ty2 geschaltet, dessen Gateanschluß mit dem Drainanschluß des ersten Transistors Tx2 verbunden ist. Durch diesen zweiten Transistor Ty2 wird auch der Gateanschluß des ersten Transistor Tx2 auf das Potential des Sourceanschlusses des ersten Transistors Tx2 gebracht, so daß dieser sperrt.

Um eine Entladung des zweiten Kondensators Cp2 über den zweiten Transistor Ty2 und den ersten Taktsignalanschluß zu verhindern, ist der erste Kondensator Cb2 vorgesehen.

In erfindungsgemäßer Weise ist zwischen den Sourceanschluß des ersten Transistors Tx2 und einen Anschluß der Wanne Kw, in der der Transistor Tx2 ausgebildet ist, ein dritter NMOS-Transistor Tz2 geschaltet, dessen Gateanschluß ebenfalls mit dem Drainanschluß des ersten Transistors Tx2 verbunden ist.

Wie aus Figur 2 zu erkennen ist, sind auch der zweite und der dritte Transistor Ty2, Tz2 in der p-Wanne, in der der erste Transistor Tx2 ausgebildet ist, angeordnet. Wie durch strichlierte Linien angedeutet ist, können sie jedoch auch in eigenen Wannen ausgebildet sein, wobei die Wannen in vorteilhafter Weise durch Leitungen miteinander verbunden sind.

Durch den dritten Transistor Tz2 wird die Wanne, die in Figur 1 durch den Knoten Kw repräsentiert ist, auf einem negativen Potential gehalten, so daß der pn-Übergang zwischen der p-Wanne und der n-Wanne in Sperrichtung gepolt ist und kein Leckstrom fließen kann. Durch den dritten Transistor Tz2 wird außerdem der Wannen-Wannen-Sperrschichtkondensator Cw aufgeladen, so daß die p-Wanne auch bei Sperren des dritten Transistors Tz2 auf dem negativen Potential gehalten wird.

In Figur 2 ist außerdem ein parasitärer npn-Transistor Tp dargestellt, der durch das n⁺-Draingebiet des ersten Transistors Tx2 die p-Wanne sowie die n-Wanne gebildet wird. Dieser parasitäre Transistor Tp ist auch in Figur 1 angedeutet. Es ist deutlich zu erkennen, daß dieser Transistor leiten würde und zu einem Leckstrom führen würde, wenn die p-Wanne positiver als der Drainanschluß des ersten Transistors Tx2 würde.

Dies ist jedoch durch den erfindungsgemäßen dritten Transistor wirkungsvoll verhindert.

Wie bereits gesagt wurde, können mehrere solcher erfindungsgemäßer Schaltungsanordnungen hintereinander geschaltet werden, um nicht nur eine negative Spannung, sondern eine im Vergleich zur Versorgungsspannung hohe negative Spannung, wie sie beispielsweise für das Programmieren und Löschen von Flash-EPROM-Speichern benötigt wird, zu erzeugen.

In Figur 3 sind eine Anzahl N solcher Schaltungsanordnungen gemäß Figur 1 hintereinander geschaltet. Die ersten Transistoren sind mit Tx1 bis TxN bezeichnet. Die anderen Schaltungsbestandteile sind in äquivalenter Weise beziffert. Der zweite Kondensator CpN der n-ten Schaltungsanordnung ist nicht mit einer Taktsignalspannung beaufschlagt, da an ihm die negative Hochspannung abgegriffen werden soll. Mit einer solchen Ladungspumpe, wie sie in Figur 3 dargestellt ist, die aus N Pumpenstufen besteht, kann eine Spannung von (N-1) · U₀ erzeugt werden, wenn der Eingang der ersten Pumpenstufe mit Masse beaufschlagt ist und U₀ der Pegel der Taktsignale ist. Die Taktsignale F1...F4 haben dabei die zeitlichen Verläufe, wie sie in Figur 6 dargestellt sind. Die Taktsignal F3 und F4 haben denselben zeitlichen Verlauf wie die Taktsignale F1 und F2, sind jedoch um eine halbe Periodendauer verschoben.

Die ungeradzahligen Pumpstufen der Ladungspumpe gemäß Figur 3 sind mit den Taktsignal F3 und F4 beaufschlagt und die geradzahligen mit den Taktsignalen F1 und F2.

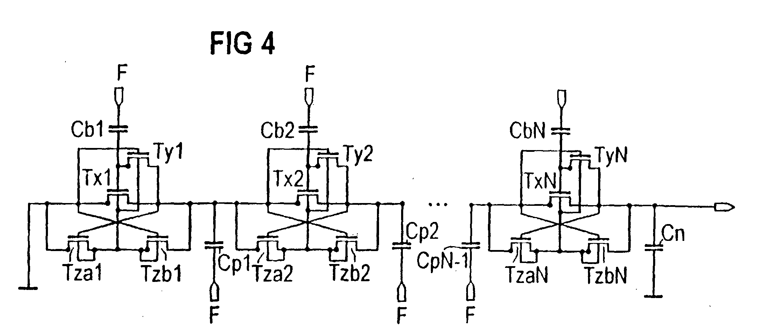

Figur 4 zeigt eine weitere Ausführungsform der Erfindung. Bei den Schaltungsanordnungen der dort dargestellten Ladungspumpe sind vierte NMOS-Transistoren Tza1...TzaN zwischen den Drainanschlüssen der ersten Transistoren Tx1...TxN und den Wannen angeordnet. Die Gateanschlüsse der vierten Transistoren Tza1...TzaN sind jeweils mit den Sourceanschlüssen der ersten Transistoren Tx1...TxN verbunden. Die dritten Transistoren sind hier mit Tzb1...TzbN bezeichnet.

Die vierten Transistoren Tza1...TzaN sorgen dafür, daß auch im Fall, daß an den Drainanschlüssen der ersten Transistoren Tx1 ... TxN ein niedereres Potential als an deren Sourceanschlüssen anliegt, dieses niederste Potential zu den Wannen durchgeschaltet wird und die Wannen somit immer auf den niedersten der beiden Potentiale liegt.

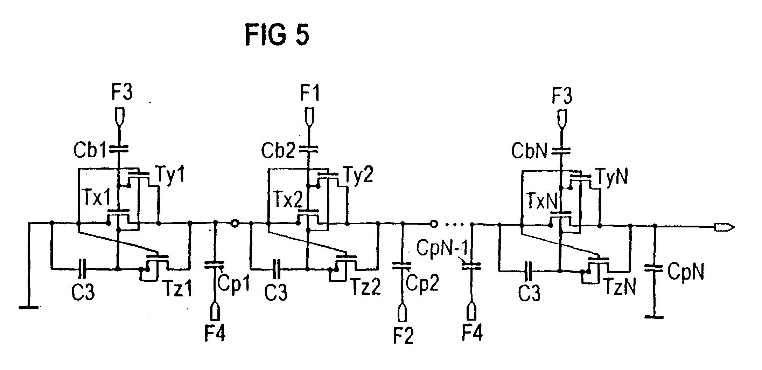

Statt der vierten Transistoren Tza1...TzaN kann in vorteilhafter Weiterbildung der Schaltungsanordnung gemäß Figur 1 bzw. der Ladungspumpe gemäß Figur 3 ein dritten Kondensator C3 zwischen die Drainanschlüsse der ersten Transistoren Tx1...TxN und die Wannen Kw geschaltet werden. Dies ist in Figur 5 dargestellt. Die dritten Kondensatoren C3 führen in Verbindung mit den Wannen-Wannen-Kondensatoren Cw (die in Figur 5 nicht explizit dargestellt sind) zu einem weiteren Absinken des Wannenpotentials.

Die in den Figuren 3 bis 5 dargestellten erfindungsgemäßen Ladungspumpen zeichnen sich durch eine hohe Effizienz aus, so daß auch bei kleiner Versorgungsspannung von etwa 2,5V Ausgangsspannungen von -20V erreichbar sind.

## Patentansprüche

1. Schaltungsanordnung zum Erzeugen negativer Spannungen
- mit einem ersten Transistor (Tx2), dessen erster Anschluß mit einem Eingangsanschluß (E) und dessen zweiter Anschluß mit einem Ausgangsanschluß (A) der Schaltungsanordnung verbunden ist und dessen Gateanschluß über einen ersten Kondensator (Cb2) mit einem ersten Taktsignalanschluß verbunden ist,
- mit einem zweiten Transistor (Ty2), dessen erster Anschluß mit dem Gateanschluß des ersten Transistors (Tx2), dessen zweiter Anschluß mit dem zweiten Anschluß des ersten Transistors (Tx2) und dessen Gateanschluß mit dem ersten Anschluß des ersten Transistors (Tx2) verbunden ist und mit einem zweiten Kondensator (Cp2), dessen erster Anschuß mit dem zweiten Anschluß des ersten Transistors (Tx2) und dessen zweiter Anschluß mit einem zweiten Taktsignalanschluß verbunden ist,
- wobei die Transistoren (Tx2, Ty2) in einer Triple-Well ausgebildete MOS-Transistoren sind,
**dadurch gekennzeichnet,**
daß der erste Anschluß eines dritten Transistors (Tz2) mit dem zweiten Anschluß des ersten Transistors (Tx2), der zweite Anschluß des dritten Transistors (Tz2) mit der/den die Transistoren (Tx2, Ty2, Tz2) beinhaltenden Wanne(n) (Kw) und der Gateanschluß des dritten Transistors (Tz2) mit dem ersten Anschluß des ersten Transistors (Tx2) verbunden ist.

2. Schaltungsanordnung nach Anspruch 1, **dadurch gekennzeichnet,** daß der erste Anschluß eines vierten Transistors (Tza2) mit dem ersten Anschluß des ersten Transistors (Tx2), der zweite Anschluß des vierten Transistors (Tza2) mit der/den die Transistoren (Tx2, Ty2, Tza2, Tzb2)) beinhaltenden Wanne(n) und der Gateanschluß des vierten Transistors (Tza2) mit dem zweiten Anschluß des ersten Transistors (Tx2) verbunden ist.

3. Schaltungsanordnung nach Anspruch 1, **dadurch gekennzeichnet,** daß der erste Anschluß eines dritten Kondensators (C3) mit dem ersten Anschluß des ersten Transistors (Tx2) und der zweite Anschluß des dritten Kondensators (C3) mit der/den die Transistoren (Tx2, Ty2, Tz2) beinhaltenden Wanne(n) (Kw) verbunden ist.

4. Ladungspumpe zum Erzeugen negativer Spannungen, bei der zumindest zwei Schaltungsanordnungen gemäß einem der Ansprüche 1 bis 3 in Serie geschaltet sind und der Eingangsanschluß der ersten dieser Schaltungsanordnungen mit Massepotential verbunden ist.

5. Verfahren zum Betreiben einer Ladungspumpe nach Anspruch 4, **dadurch gekennzeichnet** daß die Taktsignale (F1, F2 bzw. F3, F4) an den Taktsignalanschlüssen einer jeweiligen Schaltungsanordnung um eine halbe Periodendauer gegenüber den Taktsignalen (F3, F4 bzw. F1, F2) der voranstehenden Schaltungsanordnung verschoben sind.

6. Verfahren nach Anspruch 5, **dadurch gekennzeichnet,** daß das Tastverhältnis zumindest der Taktsignale (F2, F4) an den zweiten Taktsignalanschlüssen größer als 0.5 ist.

## Claims

1. Circuit arrangement for producing negative voltages,
- with a first transistor (Tx2), whose first connection is connected to an input connection (E), whose second connection is connected to an output connection (A) of the circuit arrangement and whose gate connection is connected to a first clock signal connection via a first capacitor (Cb2),
- with a second transistor (Ty2), whose first connection is connected to the gate connection of the first transistor (Tx2), whose second connection is connected to the second connection of the first transistor (Tx2) and whose gate connection is connected to the first connection of the first transistor (Tx2), and
- with a second capacitor (Cp2), whose first connection is connected to the second connection of the first transistor (Tx2) and whose second connection is connected to a second clock signal connection,
- the transistors (Tx2, Ty2) being MOS transistors produced in a triple well,
characterized
in that the first connection of a third transistor (Tz2) is connected to the second connection of the first transistor (Tx2), the second connection of the third transistor (Tz2) is connected to the well(s) (Kw) containing the transistors (Tx2, Ty2, Tz2), and the gate connection of the third transistor (Tz2) is connected to the first connection of the first transistor (Tx2).

2. Circuit arrangement according to Claim 1,
characterized in that the first connection of a fourth transistor (Tza2) is connected to the first connection of the first transistor (Tx2), the second connection of the fourth transistor (Tza2) is connected to the well(s) containing the transistors (Tx2, Ty2, Tza2, Tzb2), and the gate connection of the fourth transistor (Tza2) is connected to the second connection of the first transistor (Tx2).

3. Circuit arrangement according to Claim 1,
characterized in that the first connection of a third capacitor (C3) is connected to the first connection of the first transistor (Tx2), and the second connection of the third capacitor (C3) is connected to the well(s) (Kw) containing the transistors (Tx2, Ty2, Tz2).

4. Charge pump for generating negative voltages, in which at least two circuit arrangements according to one of Claims 1 to 3 are connected in series and the input connection of the first of these circuit arrangements is connected to earth potential.

5. Method of operating a charge pump according to Claim 4, characterized in that the clock signals (F1, F2 and F3, F4 respectively) at the clock signal connections of a respective circuit arrangement are shifted by half a clock period of the clock signals (F3, F4 and F1, F2 respectively) of the preceding circuit arrangement.

6. Method according to Claim 5, characterized in that the duty ratio of at least the clock signals (F2, F4) at the second clock signal connections is greater than 0.5.

## Revendications

1. Montage pour produire des tensions négatives
- comportant un premier transistor (Tx2) dont la première borne est reliée à une borne (E) d'entrée et dont la deuxième borne est reliée à une borne (A) de sortie du montage et dont la borne de grille est reliée par l'intermédiaire d'un premier condensateur (Cb2) à une première borne de signaux d'horloge,
- comportant un deuxième transistor (Ty2) dont la première borne est reliée à la borne de grille du premier transistor (Tx2), dont la deuxième borne est reliée à la deuxième borne du premier transistor (Tx2) et dont la borne de grille est reliée à la première borne du premier transistor (Tx2) et
- comportant un deuxième condensateur (Cp2) dont la première borne est reliée à la deuxième borne du premier transistor (Tx2) et dont la deuxième borne est reliée à une deuxième borne de signaux d'horloge,
- les transistors (Tx2, Ty2) étant des transistors MOS réalisés en triple well,
caractérisé en ce que la première borne d'un troisième transistor (Tz2) est reliée à la deuxième borne du premier transistor (Tx2), la deuxième borne du troisième transistor (Tz2) est reliée à la cuvette (Kw) ou aux cuvettes contenant les transistors (Tx2, Ty2, Tz2) et la borne de grille du troisième transistor (Tz2) est reliée à la première borne du premier transistor (Tx2).

2. Montage suivant la revendication 1, caractérisé en ce que la première borne d'un quatrième transistor (Tza2) est reliée à la première borne du premier transistor (Tx2), la deuxième borne du quatrième transistor (Tza2) est reliée à la cuvette ou aux cuvettes contenant les transistors (Tx2, Ty2, Tza2, Tzb2) et la borne de grille du quatrième transistor (Tza2) est reliée à la deuxième borne du premier transistor (Tx2).

3. Montage suivant la revendication 1, caractérisé en ce que la première borne d'un troisième condensateur (C3) est reliée à la première borne du premier transistor (Tx2) et la deuxième borne du troisième condensateur (C3) est reliée à la cuvette (Kw) ou aux cuvettes contenant les transistors (Tx2, Ty2, Tz2).

4. Pompe de charge pour produire des tensions négatives, dans laquelle au moins deux montages suivant l'une des revendications 1 à 3 sont branchés en série et la borne d'entrée du premier de ces montages est reliée au potentiel de masse.

5. Procédé pour faire fonctionner une pompe de charge suivant la revendication 4, caractérisé en ce que les signaux (F1, F2 et F3, F4) d'horloge aux bornes de signaux d'horloge d'un montage associé sont décalés de la moitié de la durée d'une période par rapport aux signaux (F3, F4 et F1, F2) d'horloge du montage en amont.

6. Procédé suivant la revendication 5, caractérisé en ce que le rapport de durée d'impulsion au moins des signaux (F2, F4) d'horloge aux deuxièmes bornes de signaux d'horloge est supérieur à 0,5.
